(19) **Europäisches Patentamt European Patent Office Office européen des brevets**

(11) **EP 4 624 626 A1**

(12) **EUROPEAN PATENT APPLICATION**

(43) Date of publication:
   **01.10.2025 Bulletin 2025/40**

(21) Application number: **24166467.1**

(22) Date of filing: **26.03.2024**

(51) International Patent Classification (IPC):
   **C23C 28/00** (2006.01)   **C23C 14/34** (2006.01)

(52) Cooperative Patent Classification (CPC):
   **C23C 28/345; C23C 14/34; C23C 28/321**

(84) Designated Contracting States:
   **AL AT BE BG CH CY CZ DE DK EE ES FI FR GB GR HR HU IE IS IT LI LT LU LV MC ME MK MT NL NO PL PT RO RS SE SI SK SM TR**
   Designated Extension States:
   **BA**
   Designated Validation States:
   **GE KH MA MD TN**

(71) Applicant: **Jozef Stefan Institute**
   **1000 Ljubljana (SI)**

(72) Inventors:
   • **Nemanic, Vincenc**
     **1000 Ljubljana (SI)**
   • **Zumer, Marko**
     **1000 Ljubljana (SI)**
   • **Cvelbar, Uros**
     **1000 Ljubljana (SI)**

(74) Representative: **Mewburn Ellis LLP**
   **Aurora Building**
   **Counterslip**
   **Bristol BS1 6BX (GB)**

(54) **METHOD OF FORMING A HYDROGEN PERMEATION BARRIER ON A METAL SUBSTRATE**

(57)   The present invention provides a method of forming a hydrogen permeation barrier on a metal substrate, by heating the substrate and exposing the substrate to a mixed gas supply. The method beneficially and efficiently provides a thin layer that inhibits hydrogen permeation. The invention also relates to an article for the storage or transport of hydrogen, and to the use of a sheet comprising particular layers in the storage or transport of hydrogen.

## Figure 3

## Description

### *Field of the Invention*

The present invention relates to a method of forming a thin hydrogen permeation barrier on a metal substrate. Such a barrier is particularly suitable for use in articles for the storage or transport of hydrogen, to which the invention also relates, such as containers and pipelines.

### *Background*

Hydrogen relatively freely permeates through most metals, presenting a significant obstacle for numerous technological applications. In particular, an effective permeation reduction of gaseous hydrogen or its isotopes into a metal wall, by the introduction of a barrier, is essential in two main fields: preventing hydrogen embrittlement in steels, and controlling the tritium inventory in future nuclear fusion reactors.

Distribution of gaseous hydrogen on a large scale in a hydrogen-based energy economy will require a dense pipeline network for its safe delivery [Jones *et al.* (2007)]. Coating and painting a bulk metal with a relatively thick impermeable layer is a widely applied solution for preventing steel corrosion. These techniques are successfully used in many items, ranging from cars to long pipelines, where the air atmosphere is harmful. Hydrogen has a different effect on steel, compared to oxygen and water, because it causes hydrogen embrittlement. Besides developing new grades of steels that are less susceptible to embrittlement, efficient Hydrogen Permeation Barriers (HPBs) on the inner side of tubes will remain an important issue.

The situation of nuclear fusion is slightly different. Most recent research has focused on future nuclear fusion reactors, using tritium as fuel [Causey *et al.* (2012)]. A small amount of tritium is prepared *in situ* and fused with deuterium into helium, or recycled within the fusion reactor. Unfortunately, a fraction of tritium can penetrate the sub-surface layer of the reactor walls in the neutral or ionised form, accumulate, and slowly penetrate through the cooling system to the atmosphere. Due to its decay half-life of 12.3 years, a substantial fraction can be accumulated in the reactor walls, thus representing a permanent radiation source. Its radiation intensity must remain below some critical limit.

In the case of the Demonstration Power Station ("DEMO"), a proposed class of nuclear fusion experimental reactors that are intended to demonstrate the net production of electric power from nuclear fusion, its walls will be made of specific low activation steel, termed "Eurofer" [Esteban *et al.* (2007)]. This is martensitic steel with high hydrogen permeability. Due to safety precautions, all inner surfaces must be coated by a highly impermeable HPB, preventing tritium retention in the walls and its permeation to the environment outside the reactor.

The requirements for HPBs are more specific than for corrosion-protective coatings, due to the high permeability of hydrogen through most metals, polymers and even many dielectrics. Suitable materials can therefore only be selected from among those with the lowest bulk hydrogen diffusivity and solubility, with further restrictions for chemical inertness and high operating temperature. Besides only a few specific metals, candidates among dielectrics are some oxides, carbides and nitrides.

Coating techniques for preparing well-adhered and perfect barriers are equally important as the material selection. Most attractive are the techniques where an ad-layer is formed simply by oxidation. Other methods require specific gas environments with strong electric and magnetic fields, limiting the ad-layer's uniform coverage over large, uneven areas. Evaluation of the achieved barrier performance is another challenging task. Several new methods, which can trace hydrogen isotopes in bulk at very low concentrations, often fail to determine their mobility. Also, they do not reveal the role of barrier defects.

Using modern vacuum instrumentation techniques, even the most effective barriers can be well characterised by dynamic or gas-accumulation methods. The classical gas permeation rate method is still the most reliable option for determining the actual HPB efficiency. At elevated temperatures, the hydrogen permeation rate is recorded at the downstream side of a coated membrane exposed to a substantially higher hydrogen upstream pressure. There is no prescribed and unique definition of HPB efficiency, as it is always related to a particular experimental evaluation set-up.

Previous attempts to introduce a barrier have generally involved depositing layers having a thickness of one or more micrometres ($\geq 1$ $\mu$m) on a metal wall. For example, US 20130171442 A1 discloses a method for modifying a porous substrate, involving coating a metal hydroxide layer on the substrate and subsequently calcining to transform the metal hydroxide layer into a continuous metal oxide layer, thus forming a modified porous substrate. In particular, this document discloses a stainless steel substrate coated with an aluminium hydroxide layer containing lithium (of about 3 $\mu$m thickness), which is then transformed to an $Al_2O_3$ layer, before a Pd film (of about 11.5 $\mu$m thickness) is added on top.

Meanwhile, Nemanič *et al.* (2023) have published an experimental study using a chromium membrane with an oxide layer obtained through controlled oxidation, with 20 to 50 nm thickness. This publication investigates and discusses such a layer's Permeation Reduction Factor (PRF).

It would be beneficial to reduce the thickness of such barrier layers, while achieving similar or improved hydrogen permeation reduction. The present invention has been devised in light of the above considerations.

## Summary of the Invention

A first aspect of the invention is a method of forming a hydrogen permeation barrier on a metal substrate, the method comprising the steps of:

(i) heating the metal substrate to a temperature of between 25 °C and 500 °C;

(ii) exposing the heated metal substrate to a mixed gas supply, said mixed gas supply comprising hydrogen and an oxygen-containing gas; and

(iii) generating the hydrogen permeation barrier comprising one or more layers, wherein the one or more layers include a hydroxide layer.

The invention provides a method for forming a thin layer (such as an ultra-thin layer) on a metallic surface, resulting in a highly impermeable hydrogen barrier. Compared with known approaches, the method beneficially provides a layer of lower thickness (such as a metal hydroxide layer having a thickness of approximately 0.1 nm), which is produced with substantially greater efficiency. A further advantage is that the barrier can be transformed back to its initial permeable state by exposing it to dry hydrogen.

In some embodiments, the metal substrate comprises chromium.

In some embodiments, the metal substrate comprises iron. The iron may optionally be comprised in a steel, such as a carbon steel.

Thus, in some embodiments, the metal substrate comprises steel.

In some embodiments, the metal substrate comprises chromium and iron.

In some embodiments, the metal substrate comprises chromium and a steel.

In some embodiments, the metal substrate comprises a chromium layer.

In some embodiments, the metal substrate comprises a chromium layer and iron. In some embodiments, the metal substrate comprises a chromium layer and an iron-containing layer.

In some embodiments, the iron-containing layer is an iron layer or a steel layer. The iron layer may consist essentially of iron. The steel layer may consist essentially of steel.

In some embodiments, the metal substrate comprises a chromium layer and an iron layer. In some embodiments, the metal substrate consists essentially of a chromium layer and an iron-containing layer.

In some embodiments, the metal substrate comprises a chromium layer and a steel. In some embodiments, the metal substrate comprises a chromium layer and a steel layer. In some embodiments, the metal substrate consists essentially of a chromium layer and a steel layer.

Preferably, the chromium layer is an outermost layer - i.e. in step (ii) of the method, the chromium layer is exposed to the mixed gas supply.

In some embodiments, the metal substrate comprises a carbon steel.

In some embodiments, the metal substrate comprises a stainless steel.

In some embodiments, the metal substrate comprises a martensitic stainless steel.

In some embodiments, the metal substrate comprises Eurofer 97 (which may be alternatively referred to simply as "Eurofer").

The metal substrate is heated to a temperature of between 25 °C and 500 °C in step (i) of the method of the invention. Suitably, the metal substrate is exposed to the mixed gas supply at this temperature in step (ii) of the method.

In some embodiments, in the heating of step (i), the metal substrate is heated to a temperature of at least 30 °C, or at least 50 °C, or at least 75 °C, or at least 100 °C, or at least 150 °C, or at least 200 °C, or at least 250 °C, or at least 300 °C, or at least 350 °C, or at least 400 °C.

In some embodiments, in the heating of step (i), the metal substrate is heated to a temperature of at least 50 °C, or at least 150 °C, or at least 300 °C.

In some embodiments, in the heating of step (i), the metal substrate is heated to a temperature of at least 300 °C.

In some embodiments, in the heating of step (i), the metal substrate is heated to a temperature of at most 475 °C, or at most 450 °C, or at most 425 °C, or at most 400 °C.

In some embodiments, in the heating of step (i), the metal substrate is heated to a temperature of at most 400 °C.

In some embodiments, in the heating of step (i), the metal substrate is heated to a temperature of between 50 °C and 500 °C, or between 200 °C and 450 °C, or between 300 °C and 400 °C.

In some embodiments, in the heating of step (i), the metal substrate is heated to a temperature of between 300 °C and 400 °C.

In some embodiments, in step (i), the metal substrate is additionally placed under sub-atmospheric pressure. That is to say that the metal substrate, in addition to being heated, may also be placed under sub-atmospheric pressure. That is also to say that the heated metal substrate, when exposed to the mixed gas supply in step (ii), may be under sub-atmospheric pressure. The metal substrate may first be heated and then the heated metal substrate may be placed under sub-atmospheric pressure; or the metal substrate may first be placed under sub-atmospheric pressure and then the heating may take place at the sub-atmospheric pressure; or the heating and the pressure reduction may take place at the same time.

By "sub-atmospheric pressure", it is meant that, in step (i) in these embodiments, the metal substrate is placed in a space or system in which the pressure is lower than atmospheric pressure, such as less than 1 atmosphere, or at most 100,000 Pa, or at most 50,000 Pa, or at most 10,000 Pa, or at most 1,000 Pa, or at most 100 Pa, or at most 10 Pa, or at most 1 Pa, or at most $10^{-1}$ Pa, or at most $10^{-2}$ Pa, or at most $10^{-3}$ Pa, or at most $10^{-4}$ Pa, or at most $10^{-5}$ Pa, or at most $10^{-6}$ Pa.

In some embodiments, the sub-atmospheric pressure is a vacuum. That is to say, in some embodiments, in step (i), the metal substrate (in addition to being heated) is placed in a vacuum. By a "vacuum", it is meant that, in step (i) in these embodiments, the metal substrate is placed in a space or system in which the pressure is considerably lower than atmospheric pressure, such as at most 10 Pa, or at most 1 Pa, or at most $10^{-1}$ Pa, or at most $10^{-2}$ Pa, or at most $10^{-3}$ Pa, or at most $10^{-4}$ Pa, or at most $10^{-5}$ Pa, or at most $10^{-6}$ Pa. In some embodiments, the vacuum has a pressure of at least an ultra-high vacuum, i.e. the vacuum has a pressure of at most $10^{-6}$ Pa ($10^{-8}$ mbar).

It will be understood that step (ii) of the method of the invention takes place in the same space or system as step (i). For example, the space or system may be a sealed cell. The space or system may have an upstream part with respect to the metal substrate (where the mixed gas supply is provided) and a downstream part with respect to the metal substrate. The downstream part may be separated from the upstream part (e.g. by the presence of the metal substrate) in such a way that the mixed gas supply can essentially only travel between the upstream part and the downstream part by permeating through the (heated) metal substrate. Thus, if desired, the permeation may be measured in the downstream part.

In some embodiments, prior to step (i), the method comprises a step of adding a chromium layer to a metal substrate precursor. For example, a chromium layer may be deposited on a metal substrate precursor, such as by triode sputtering. The metal substrate precursor may comprise or consist essentially of iron or a steel. The metal substrate precursor may comprise an iron-containing layer, such as an iron layer or a steel layer.

In some embodiments, the chromium layer has a thickness of at most 15 $\mu$m, or at most 10 $\mu$m, or at most 8.0 $\mu$m, or at most 6.0 $\mu$m, or at most 4.0 $\mu$m, or at most 2.0 $\mu$m, or at most 1.0 $\mu$m.

In some embodiments, the chromium layer has a thickness of at least 0.01 $\mu$m, or at least 0.1 $\mu$m, or at least 0.5 $\mu$m, or at least 1.0 $\mu$m, or at least 1.5 $\mu$m, or at least 2.0 $\mu$m, or at least 2.5 $\mu$m, or at least 3.0 $\mu$m.

In some embodiments, prior to step (ii) (i.e. prior to exposing the heated metal substrate to a mixed gas supply), the method comprises a step of exposing the heated metal substrate to an initial hydrogen gas supply. Suitably, the initial hydrogen gas supply is a gas supply comprising or consisting essentially of $H_2$ (hydrogen). This step may be preferable in order to determine the initial permeability of the metal substrate.

Suitably, the mixed gas supply is a gas supply comprising or consisting essentially of Hz (hydrogen) and an oxygen-containing gas.

Suitably, the oxygen-containing gas is a gas that is a source of oxygen atoms. The oxygen-containing gas may be an OH-containing or-forming gas. In some embodiments, the oxygen-containing gas is Oz (oxygen) or $H_2O$ (water, i.e. steam).

In some embodiments, the mixed gas supply comprises or consists essentially of $H_2$ and $O_2$. In some embodiments, the mixed gas supply comprises or consists essentially of $H_2$ and $H_2O$. In some embodiments, the mixed gas supply comprises or consists essentially of $H_2$, $O_2$ and $H_2O$.

In some embodiments, the mixed gas supply comprises hydrogen and oxygen in an atomic ratio (H:O) of at least 80:20, or at least 85:15, or at least 90:10, or at least 95:5.

In some embodiments, the mixed gas supply comprises hydrogen and oxygen in an atomic ratio (H:O) of at least 80:20.

In some embodiments, the mixed gas supply comprises hydrogen and oxygen in an atomic ratio (H:O) of at least 95:5. An atomic ratio (H:O) of at least 95:5 may be preferred for safety reasons (to reduce the risk of explosion).

In some embodiments, the mixed gas supply comprises hydrogen and oxygen in an atomic ratio (H:O) of at most 99.9:0.1, or 99.7:0.3, or 99.5:0.5, or at most 99:1, or at most 97:3, or at most 95:5.

In some embodiments, the mixed gas supply comprises hydrogen and oxygen in an atomic ratio (H:O) of at most 99.7:0.3. In some embodiments, the mixed gas supply comprises hydrogen and oxygen in an atomic ratio (H:O) of at most 99:1.

In some embodiments, the mixed gas supply comprises hydrogen and oxygen in an atomic ratio (H:O) of at between 95:5 and 99.7:0.3.

In some embodiments, the oxygen-containing gas is Oz or HzO, and the mixed gas supply comprises hydrogen and oxygen in an atomic ratio (H:O) of between 95:5 and 99.7:0.3.

In some embodiments, the mixed gas supply is supplied at approximately atmospheric pressure, such as from 80 kPa to 120 kPa, or from 90 to 110 kPa, or from 95 to 105 kPa. In some embodiments, the mixed gas supply is supplied at a pressure above atmospheric pressure, such as at least 120 kPa.

Suitably, step (iii) of the method occurs concurrently with step (ii) of the method. That is to say, as the metal substrate is exposed to the mixed gas supply, this will result in the generation of the hydrogen permeation barrier on the metal substrate.

Generally, it is found that the amount of time taken to generate the hydrogen permeation barrier on the metal surface is shorter when the oxygen content in the mixed gas supply is increased. In some embodiments, the metal substrate is exposed to the mixed gas supply for at least 1 second, or at least 10 seconds, or at least 1 minute, or at least 2 minutes, or at least 5 minutes. In some embodiments, the metal substrate is exposed to the mixed gas supply for at most 20 minutes, or at most 10 minutes, or at most 5 minutes, or at most 2 minutes, or at most 1 minute, or at most 10 seconds.

Suitably, the hydrogen permeation barrier is generated on the metal substrate, effectively shielding a surface of the metal substrate from the surrounding atmosphere.

In some embodiments, the hydrogen permeation barrier comprises at least two layers, or at least three layers, or at least four layers.

In some embodiments, the hydrogen permeation barrier comprises one layer, or two layers, or three layers, or four layers.

At least one of the layers of the hydrogen permeation barrier is a hydroxide layer. Preferably, the hydroxide layer is an outermost layer of the hydrogen permeation barrier. For example, where the hydrogen permeation barrier comprises a hydroxide layer and one other layer, preferably the one other layer is formed on the metal substrate and the hydroxide layer is formed on the one other layer. For example, where the hydrogen permeation barrier comprises a hydroxide layer and one or more other layers, preferably the hydroxide layer is separated from the metal substrate by the one or more other layers.

In some embodiments, the hydroxide layer has a thickness of at most 1 nm, or at most 0.8 nm, or at most 0.6 nm. In some embodiments, the hydroxide layer has a thickness of at most 1 nm. The thickness may be estimated by X-ray photoelectron spectroscopy (XPS).

In some embodiments, the hydroxide layer has a minimum thickness corresponding to a monolayer. In some embodiments, the hydroxide layer is a monolayer. That is to say, the layer is effectively two-dimensional, being essentially one molecule thick.

In some embodiments, the hydroxide layer is a chromium hydroxide layer. For example, where the metal substrate comprises chromium, such as a chromium layer, at least part of this chromium may react with the mixed gas supply to form a chromium hydroxide layer.

In some embodiments, the one or more layers of the hydrogen permeation barrier further include an oxide layer.

In some embodiments, the oxide layer is a chromium oxide layer.

In some embodiments, the hydrogen permeation barrier comprises a hydroxide layer and an oxide layer.

In some embodiments, the hydrogen permeation barrier consists of a hydroxide layer and an oxide layer.

In some embodiments, the hydrogen permeation barrier comprises a chromium hydroxide layer and a chromium oxide layer.

In some embodiments, the hydrogen permeation barrier consists of a chromium hydroxide layer and a chromium oxide layer.

In some embodiments, the hydroxide layer (such as a chromium hydroxide layer) is formed on the oxide layer (such as a chromium oxide layer), which is formed on the metal substrate (such as a chromium layer).

Preferably, the hydroxide layer (such as the chromium hydroxide layer) is of lower thickness than the oxide layer (such as the chromium oxide layer).

The Permeation Reduction Factor (PRF) [as defined herein, see also Nemanič V. (2019)] is a convenient parameter by which to express barrier efficiency as a quotient between hydrogen permeation rate through uncoated metal substrate (having no hydrogen permeation barrier) and through metal substrate coated with the hydrogen permeation barrier. In some embodiments, the hydrogen permeation barrier on the metal substrate provides a PRF of at least 1000, or at least 2000, or at least 3000, or at least 4000, or at least 5000, or at least 6000, or at least 7000. In some embodiments, the hydrogen permeation barrier on the metal substrate provides a PRF of at least 1000. In some embodiments, the hydrogen permeation barrier on the metal substrate provides a PRF of at least 5000.

In some embodiments, the method further comprises a step of removing the hydroxide layer by exposing the hydrogen permeation barrier to a dry hydrogen gas supply. By "dry" hydrogen gas supply, it is meant that the gas supply does not comprise an oxygen-containing gas. The dry hydrogen gas supply comprises, and preferably consists essentially of, hydrogen. The hydrogen reacts with (and thus removes) the hydroxide groups on the surface, forming water. This step beneficially allows for the method to be reversible, as required.

Preferably, in the step of removing the hydroxide layer, the hydrogen permeation barrier is exposed to the dry hydrogen supply at a temperature of at least 300 °C or at least 400 °C.

A second aspect of the invention is an article for the storage or transport of hydrogen, wherein the article comprises walls having an iron-containing layer, a chromium layer, a chromium oxide layer and a chromium hydroxide layer. The chromium oxide layer and the chromium hydroxide layer may collectively represent a hydrogen permeation barrier, which is formed on the chromium layer and iron-containing layer (which two layers may collectively represent a metal substrate).

In some embodiments, all walls of the article have an iron-containing layer, a chromium layer, a chromium oxide layer and a chromium hydroxide layer.

In some embodiments, the iron-containing layer is an iron layer or a steel layer.

In some embodiments, the article is a hydrogen storage tank, a nuclear fusion reactor or a pipeline.

A third aspect of the invention provides the use of a sheet comprising an iron-containing layer, a chromium layer, a chromium oxide layer and a chromium hydroxide layer in the storage or transport of hydrogen. Such a sheet will have excellent properties for significantly reducing or preventing hydrogen permeation, and thus may be used in applications such as a hydrogen storage tank, a nuclear fusion reactor or a pipeline.

In the second and third aspects (and the first aspect, where applicable), preferably, the chromium hydroxide layer is formed on the chromium oxide layer; and/or preferably, the chromium oxide layer is formed on the chromium layer; and/or preferably, the chromium layer is formed on the iron-containing layer (such as an iron layer or a steel layer).

The invention includes the combination of the aspects and preferred features described except where such a combination is clearly impermissible or expressly avoided. Preferred features mentioned in relation to the first aspect of the invention may apply equally to the other aspects.

### *Summary of the Figures*

Embodiments and experiments illustrating the principles of the invention will now be discussed with reference to the accompanying figures in which:

**Figure 1** shows a schematic drawing of the permeation rate evaluation set-up;

**Figure 2** shows the effect of a hydrogen permeation barrier comprising chromium oxide, compared with a palladium-containing reference sample;

**Figure 3** shows the effect of a hydrogen permeation barrier comprising chromium oxide and chromium hydroxide, compared with a palladium-containing reference sample;

**Figure 4** shows a FIB-SEM cross-section of the chromium film;

**Figure 5** shows an XPS depth profile study of the chromium oxide surface layer;

**Figure 6** shows deconvoluted high-resolution XPS spectra just after the permeation cycle with hydrogen and 5% $O_2$;

**Figure 7** shows time-resolved *in situ* DRIFT (Drift Reflectance Infrared Fourier Transform) spectra of $CrO_x$ in different atmospheres at 400 °C;

**Figure 8** shows details of a membrane for evaluation of hydrogen permeation barrier efficiency.

### *Detailed Description of the Invention*

Aspects and embodiments of the present invention will now be discussed with reference to the accompanying figures. Further aspects and embodiments will be apparent to those skilled in the art. All documents mentioned in this text are incorporated herein by reference.

The following set of examples of the invention involve the *in situ* formation and decomposition of an ultra-thin barrier on a metal substrate, including measurement of the hydrogen permeability. In this set of examples, five samples were produced, in each of which a dense and defect-free chromium film was deposited on a solid martensitic steel base, forming a double-layered membrane. Subsequently, a hydrogen permeation barrier was generated on the metal substrate.

### *Sample Preparation*

0.5 mm thick samples of optically polished Eurofer 97 (40 mm O.D.) were selected. Eurofer 97 is a reduced-activation tempered martensitic steel, which is a particularly suitable structural material for future nuclear fusion reactors, and which has the following chemical composition (wt%): 0.11 C, 8.7 Cr, 1.0 W, 0.10 Ta, 0.19 V, 0.44 Mn, 0.004 S and balance Fe. Eurofer 97 is strong and highly permeable.

Thin chromium films were deposited in a Balzers Spruton experimental unit, which applies the principle of triode sputtering, where a thermionic arc is formed between the ionisation chamber with a hot filament and an auxiliary ring-shaped anode. The arc parameters were 40 V × 50 A at 0.2 Pa argon pressure. The chromium target (PI-KEM, 99.95%) was the cathode placed in the centre of the anode ring. The cathode voltage was 1800 V, and a 0.7 A current was maintained. The typical deposition temperature was 130 °C. The deposition rate for chromium was in the order of 0.8 $\mu$m/h. The duration of all depositions was 4 h, giving a chromium layer thickness of about 3.3 $\mu$m.

As a reference sample, an additional membrane was prepared with a palladium film (having a thickness of approximately 100 nm) sputtered over the 3.3 $\mu$m chromium film.

### *Initial Permeation*

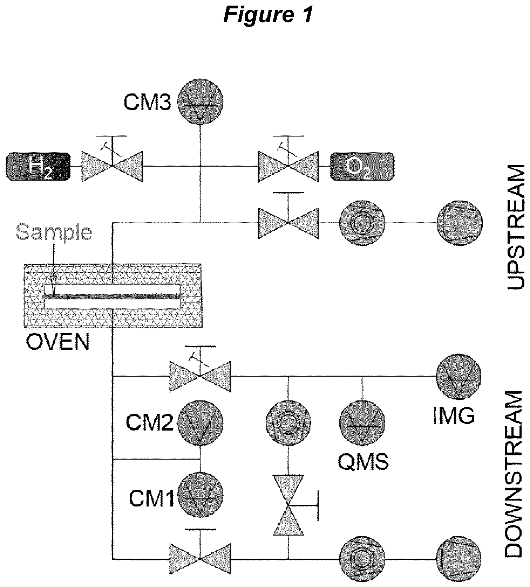

Next, the membrane was mounted in a permeation cell for each sample in turn and sealed by a golden gasket at both sides. An all-metal ultra-high vacuum (UHV) system was applied to the permeation cell for all permeation rate evaluations and intermediate oxidation cycles (i.e. all hydrogen and oxygen tests were performed without disassembling the seals). The particular investigated membrane separated the upstream and downstream parts. This is depicted in Figure 1, which shows a schematic drawing of the permeation rate evaluation set-up, in which CM1, CM2 and CM3 are capacitance manometers, IMG is an inverted magnetron gauge, and QMS is a quadrupole mass spectrometer.

The permeation cell was then heated within 4 hours to 400 °C. Next, pure hydrogen gas (99.999%) was admitted to the upstream part of the cell, and the membrane was exposed to the gas in a controlled manner at the elevated temperature of 400 °C and a pressure of 1 bar (pressure monitored by capacitance manometer CM3).

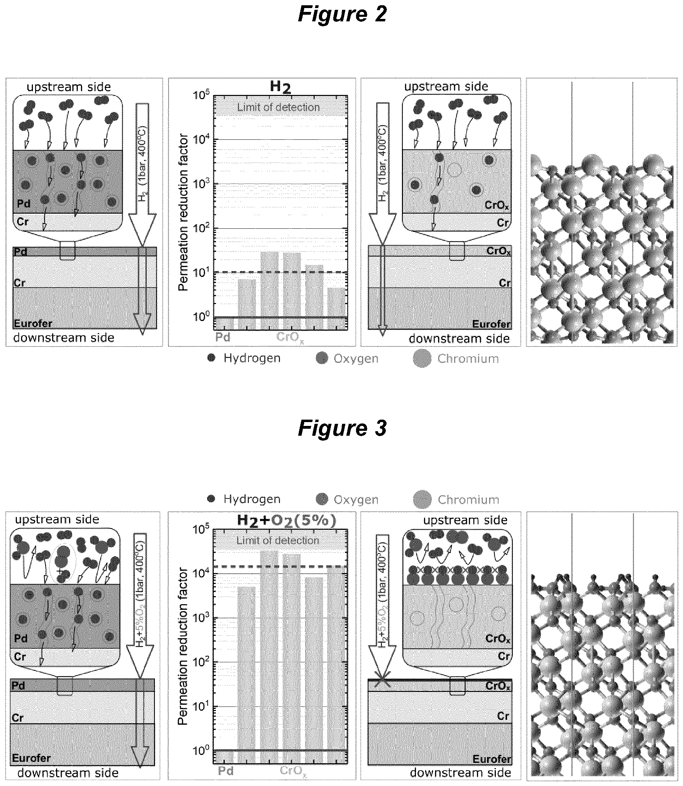

A thin chromium oxide was formed during this process (except in the reference membrane containing the palladium film). The rise in pressure in the closed downstream part revealed the initial permeability value of the membranes. Figure 2 shows the Permeation Reduction Factor (PRF) values calculated for the five samples and the Pd-containing reference sample, in a graph in which each bar represents an individual sample. Figure 2 also depicts a schematic drawing of the layers and the $H_2$ permeation (showing that the $CrO_x$ or Pd layer faced the upstream part). In this case, where pure hydrogen had been used, moderate suppression of the hydrogen permeation rate by the chromium oxide was observed, with PRF values from about 4.5 to about 39 compared to the Pd-containing reference membrane (which has a PRF value of 1 by definition).

The difference in PRFs over these samples was believed to result from various native oxide thicknesses and a slight variation in partial water pressure, causing oxidation during pre-processing at 400 °C in high vacuum.

### Hydroxide-containing Barrier

Subsequently, the gas content of the permeation cell was varied by introducing oxygen. This was done by preparing a mixture of approximately 4 kPa oxygen and approximately 80 kPa hydrogen in the upstream part (an atomic ratio H:O of about 95:5). Otherwise, the conditions were the same as above (i.e. the membrane was exposed to the gas supply at a temperature of 400 °C and a pressure of 1 bar).

In this case, for the five samples, an ultra-thin chromium hydroxide layer was formed on the chromium oxide surface. This resulted in a complete, immediate and permanent blocking of hydrogen permeation. It is assumed that the hydroxyl groups form a barrier that prevents hydrogen dissociation being the first step in a permeation process. Conversely, for the Pd-containing reference sample, no change in the hydrogen permeation rate was observed.

Figure 3 shows the PRF values that were calculated for the five samples and the Pd-containing reference sample, in a graph in which each bar represents an individual sample. Figure 3 also depicts a schematic drawing of the layers and the $H_2$ permeation (showing the ultra-thin hydroxide layer facing the upstream part, on the $CrO_x$ layer). In this case, where a source of oxygen was added to hydrogen in the gas supply, a PRF of at least 5000 was observed compared to the Pd-containing reference membrane (which has a PRF value of 1).

The beneficial results observed in the present invention are surprising. The topic of hydrogen/water interaction at a catalytic surface is rather well described by theoretical models and supported by experiments with noble metals (Pt, Pd etc.). Theoretical descriptions of phenomena leading to "site blocking" have been published [e.g. see Henderson *et al.* (2002)]. Experimental evidence caused by CO has been observed at low temperatures. However, on the contrary, there is no known prior art demonstrating this effect at elevated temperature, causing blocking of hydrogen permeation flow.

### Removing the Hydroxide Layer

Subsequently, by replacing the mixed gas supply with "dry" hydrogen (absent of oxygen or water), the initial PRF values were recovered. This indicated that the chromium hydroxide layer decomposes in the absence of oxygen or water. The decomposition of the barrier hydroxyl groups enables hydrogen dissociation, and allows the next phases of the permeation process to proceed.

In summary, the barrier may be transformed back into the highly permeable state as desired, by exposing it to dry hydrogen (such as pure hydrogen) at an elevated temperature of at least 300 °C (such as about 400 °C, or at least 400 °C).

A very similar catalytic reaction is applied on the catalyst surface for suppressing the risk of self-explosion of hydrogen-oxygen mixtures in nuclear and fusion reactors by using passive auto-catalytic recombiners (PARs) [Steffen *et al.* (2019)].

### Further Experiments

Experimental verification of the observed results was realised by complementary spectroscopic and microscopic methods.

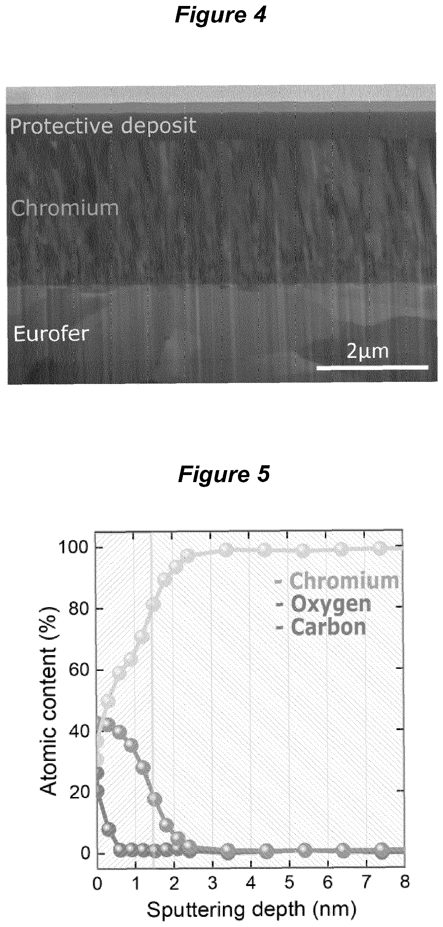

Figure 4 shows a FIB-SEM cross-section of the chromium film, revealing the columnar internal structure and large grain sizes of Eurofer beneath. After permeation measurements, a protective layer was added on top of Cr to improve the image contrast and to preserve the nanometric barrier.

Figure 5 shows an XPS depth profile study of the chromium oxide surface layer (without a protective deposit) after heating at 400 °C for 18 hours in a vacuum at $10^{-7}$ Pa. The thickness of chromium oxide formed on the surface before and during vacuum processing was found to be between 1 and 2 nm, as determined by the study using Ar-gun sputtering.

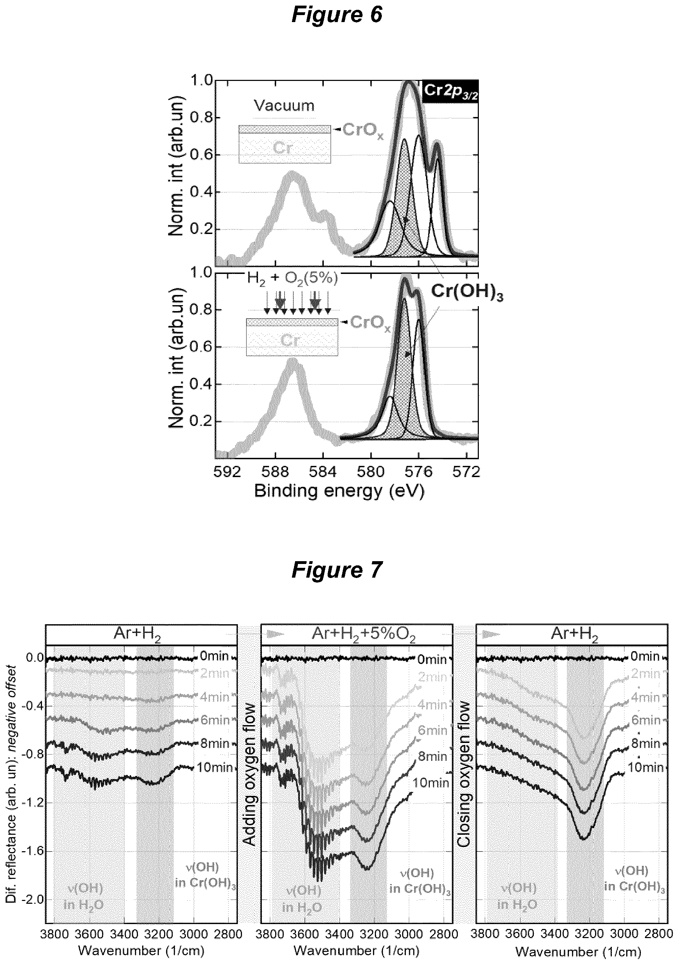

Figure 6 shows deconvoluted high-resolution XPS spectra after the permeation cycle with hydrogen and 5% Oz, indicating an increased share of $Cr(OH)_3$ (shaded peak at 577.2 eV) into the $Cr_{2p3/2}$ core level profile.

Figure 7 shows time-resolved *in situ* DRIFT (Drift Reflectance Infrared Fourier Transform) spectra of $CrO_x$ in different atmospheres at 400 °C, with Ar+$H_2$

on the left, Ar+H$_2$+5%O$_2$ in the middle, and Ar+Hz on the right. The spectra show the formation and disintegration of two OH groups, one for water and another for chromium hydroxide. The spectra confirm the catalytic nature of gas-phase water formation and the appearance of an atomically thin hydroxide layer. The ratio of hydrogen and oxygen in argon flow through the analytical DRIFT cell corresponds to the ratios in the permeation experiments.

*PRF and Permeation Considerations*

Among techniques that give an *in situ* evaluation of the hydrogen permeation barrier (HPB) is the permeation rate test of gaseous hydrogen through a coated membrane consisting of a thick metal substrate and a thin HPB deposited on the upstream side, as performed in the set of examples described herein. The thickness of the substrate is much lower than its diameter, which enables the data to be presented as one-dimensional in the direction of the hydrogen permeation. The permeation rate *j* at a specific temperature is expressed in the number of hydrogen molecules per unit time per unit area.

The substrate permeability $P_s$ at specified upstream hydrogen pressure and the temperature is known. The Permeation Reduction Factor (PRF) is defined as the steady-state ratio of the permeation rate through the uncoated membrane $j_{uncoated}$ versus the permeation rate through the coated membrane $j_{coated}$, as shown by the following equation:

$$PRF = \frac{j_{uncoated}}{j_{coated}}.$$

Whilst the PRF expresses a valuable engineering property of the HPB, it does not reveal the mechanism of permeation. The permeation rate results from several processes that hydrogen undergoes on its path through the coated membrane.

Some assumptions below enable correlating a coated membrane's PRF value to the basic HPB properties. Two crucial parameters of a particular bulk material that govern the process of hydrogen permeability *P* are the diffusion coefficient *D* and solubility *K*. The basic formalism of hydrogen transport through the bulk is suitable for idealised pure metals with high solubility. In equilibrium, Sieverts' law expresses the number of dissolved hydrogen atoms at a specified external hydrogen pressure and temperature.

Diffusivity, solubility and permeability in both layers are supposed to be known and designated to the solid substrate as $D_s$, $K_s$, and $P_s$, and for the thin HPB film as $D_f$, $K_f$, and $P_f$, respectively. It is assumed that all processes are thermally activated and can be described by the Arrhenius dependence. The diffusion coefficient *D* describes the diffusion process in any layer whose exponential temperature dependence is specified by the pre-exponential term $D_0$ and the diffusion activation energy $E_D$. Similar relations are valid for *K* and *P* in all layers [Andrew *et al.* (1992)].

Two distinguishable permeation mechanisms related to the hydrogen transport regime are introduced for a bare membrane depending on the upstream hydrogen pressure. The first is often described as the diffusion-limited regime (DLR) since bulk diffusion controls the kinetics. The second case is the surface-limited regime (SLR), as surface reactions govern the process [Shipilevsky *et al.* (1989)]. The SLR is valid at low pressures at which HPBs are assumed to be applied, but experimental evaluation of their efficiency is critical or impossible. Consequently, reported data on HPBs were recorded at high pressure and temperature, where the DLR might not be valid in all assumed details.

The DLR can be applied for coated, i.e. double-layered membranes with the same assumptions which hold for a bare membrane. The permeation is diffusion-limited in both layers, and the effective permeability coefficient $P_{eff}$ of such a double-layer is given by:

$$\frac{d_s + d_f}{P_{eff}} = \frac{d_s}{P_s} + \frac{d_f}{P_f}$$

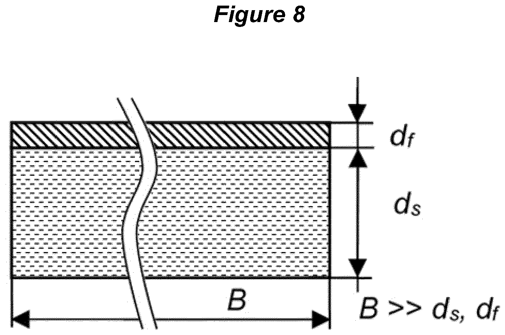

where $d_s$ denotes the substrate thickness and $d_f$ thickness of the HPB film. These are depicted in Figure 8, which shows details of a membrane for the evaluation of HPB efficiency (where B is the diameter of the membrane).

PRF and $P_f$ are related, as shown in the following equation:

$$PRF = 1 + d_f P_s / (d_s P_f).$$

For PRF >> 1, a simple correlation between $P_f$ and $P_s$ can be written as:

$$P_f \cong \frac{d_f P_s}{d_s PRF}.$$

From the experimental point of view, determining a low value of $P_f$ at a highly permeable substrate is less difficult than at a low permeable substrate as the measured permeation rate often approaches the detection limit of the setup. Many authors have had to increase the test temperature far above the scheduled operation temperature to get a reliable PRF. It could only be assumed that extrapolation to lower temperatures is a tolerable operation as $P_f$ may have a different dependence on temperature than $P_s$.

Since $D_f$ and $K_f$ are both contained in the $P_f$, they cannot be determined separately unless the time evolution of the permeation rate after a stepwise change of the driving hydrogen pressure is also recorded.

The features disclosed in the foregoing description, or in the following claims, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the spirit and scope of the invention.

For the avoidance of any doubt, any theoretical explanations provided herein are provided for the purposes of improving the understanding of a reader. The inventors do not wish to be bound by any of these theoretical explanations.

Any section headings used herein are for organisational purposes only and are not to be construed as limiting the subject matter described.

Throughout this specification, including the claims which follow, unless the context requires otherwise, the words "comprise" and "include", and variations such as "comprises", "comprising", and "including" will be understood to imply the inclusion of a stated integer or step or group of integers or steps but not the exclusion of any other integer or step or group of integers or steps.

It must be noted that, as used in the specification and the appended claims, the singular forms "a", "an", and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about", it will be understood that the particular value forms another embodiment. The term "about" in relation to a numerical value is optional and means, for example, +/- 10%.

### *References*

A number of publications are cited above in order to more fully describe and disclose the invention and the state of the art to which the invention pertains. Full citations for these references are provided below. The entirety of each of these references is incorporated herein.

Jones et al., Materials for the Hydrogen Economy, CRC (2007).

Causey et al., Tritium Barriers and Tritium Diffusion in Fusion Reactors, in: Comprehensive Nuclear Materials, vol. 4, R. J. Konings, Elsevier (2012), pg. 511-549.

Esteban et al., Hydrogen transport and trapping in Eurofer '97, J. Nucl. Mater. (2007), pg. 367-370.

US 20130171442 A1.

Nemanič et al., Impact of surface oxide on hydrogen permeability of chromium membranes, Int. J. Hydrog. Energy (2023), pg. 9723-9733.

Nemanič V., Hydrogen permeation barriers: basic requirements, materials selection, deposition methods, and quality evaluation, Nucl. Mater. Energy (2019), vol. 19, pg. 451-457.

Henderson et al., The interaction of water with solid surfaces: fundamental aspects revisited, Surf. Sci. Rep. (2002), vol. 46, pg. 1-308.

Andrew et al., Models for hydrogen permeation in metals, J. Appl. Phys. (1992), vol. 72, pg. 2749-2757.

Shipilevsky et al., Competition of bulk and surface processes in the kinetic of hydrogen and nitrogen evolution from metals into vacuum, Surface Science (1989), vol. 216, pg. 509-527.

Steffen et al., Prevention of hydrogen accumulation inside the vacuum vessel pressure suppression system of the ITER facility by means of passive auto-catalytic recombiners, Intl. J. Hydrog. Energy (2019), vol. 44, pg. 8971-8980.

### Claims

1. A method of forming a hydrogen permeation barrier on a metal substrate, the method comprising the steps of:

   (i) heating the metal substrate to a temperature of between 25 °C and 500 °C;
   (ii) exposing the heated metal substrate to a mixed gas supply, said mixed gas supply comprising hydrogen and an oxygen-containing gas; and
   (iii) generating the hydrogen permeation barrier comprising one or more layers, wherein the one or more layers include a hydroxide layer.

2. The method of claim 1, wherein the metal substrate comprises chromium.

3. The method of claim 2, wherein the metal substrate comprises chromium and iron, optionally wherein the iron is comprised in a steel.

4.  The method of claim 3, wherein the metal substrate comprises a chromium layer and an iron-containing layer, optionally wherein the iron-containing layer is an iron layer or a steel layer.

5.  The method of claim 4, wherein the metal substrate comprises a stainless steel, optionally a martensitic stainless steel.

6.  The method of any one of claims 2 to 5, wherein the hydroxide layer is a chromium hydroxide layer.

7.  The method of any one of claims 1 to 6, wherein the hydroxide layer has a thickness of at most 1 nm and/or wherein the hydroxide layer is a monolayer.

8.  The method of any one of claims 1 to 7, wherein the one or more layers of the hydrogen permeation barrier further include an oxide layer, optionally a chromium oxide layer.

9.  The method of any one of claims 1 to 8, wherein the oxygen-containing gas is Oz or $H_2O$ and/or wherein the mixed gas supply comprises hydrogen and oxygen in an atomic ratio (H:O) of between 95:5 and 99.7:0.3.

10. The method of any one of claims 1 to 9, wherein, in step (i), the metal substrate is additionally placed under sub-atmospheric pressure, optionally in a vacuum.

11. The method of any one of claims 1 to 10, wherein, in the heating of step (i), the metal substrate is heated to a temperature of between 50 °C and 500 °C, or between 200 °C and 450 °C, or between 300 °C and 400 °C.

12. The method of any one of claims 1 to 11, wherein the hydrogen permeation barrier on the metal substrate provides a Permeation Reduction Factor (PRF) of at least 1000.

13. The method of any one of claims 1 to 12, further comprising a step of removing the hydroxide layer by exposing the hydrogen permeation barrier to a dry hydrogen gas supply at a temperature of at least 300 °C or at least 400 °C.

14. An article for the storage or transport of hydrogen, wherein the article comprises walls having an iron-containing layer, a chromium layer, a chromium oxide layer and a chromium hydroxide layer; optionally wherein the iron-containing layer is an iron layer or a steel layer.

15. Use of a sheet comprising an iron-containing layer, a chromium layer, a chromium oxide layer and a chromium hydroxide layer in the storage or transport of hydrogen; optionally wherein the iron-containing layer is an iron layer or a steel layer.

## Figure 1

## Figure 2

## Figure 3

# Figure 4

# Figure 5

## Figure 6

## Figure 7

## Figure 8

$d_f$

$d_s$

$B$

$B >> d_s, d_f$

Europäisches
Patentamt

European
Patent Office

Office européen
des brevets

# EUROPEAN SEARCH REPORT

**Application Number**

EP 24 16 6467

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZAJEC BOJAN ET AL: "Hydrogen permeability through beryllium films and the impact of surface oxides", JOURNAL OF NUCLEAR MATERIALS, ELSEVIER B.V, NETHERLANDS, vol. 443, no. 1, 18 July 2013 (2013-07-18), pages 185-194, XP028770652, ISSN: 0022-3115, DOI: 10.1016/J.JNUCMAT.2013.07.020 | 1-12 | INV. C23C28/00 C23C14/34 |
| A | * sections 3.1, 3.3.1, 4.3.1, table 2 * ----- | 13-15 | |
| X | HEPING LI ET AL: "Thermochemically synthesized [alpha]-Al2O3 composite coating with high bonding strength and deuterium permeation resistance", JOURNAL OF THE AMERICAN CERAMIC SOCIETY, BLACKWELL PUBLISHING, MALDEN, MA, US, vol. 107, no. 3, 4 September 2023 (2023-09-04), pages 1871-1882, XP072560572, ISSN: 0002-7820, DOI: 10.1111/JACE.19417 | 1-3,5,7, 8,12 | |
| A | * section 2.1 * | 4,6, 9-11, 13-15 | TECHNICAL FIELDS SEARCHED (IPC) C23C |
| A | ----- TOMAS M ET AL: "Hydrogen-barrier coatings against dual-atmosphere corrosion for IT-SOFC interconnect applications", INTERNATIONAL JOURNAL OF HYDROGEN ENERGY, ELSEVIER, AMSTERDAM, NL, vol. 58, 30 January 2024 (2024-01-30), pages 852-862, XP087474027, ISSN: 0360-3199, DOI: 10.1016/J.IJHYDENE.2024.01.219 [retrieved on 2024-01-30] * the whole document * ----- -/-- | 1-15 | |

The present search report has been drawn up for all claims

| Place of search | Date of completion of the search | Examiner |
|---|---|---|
| The Hague | 17 August 2024 | Martinavicius, A |

EPO FORM 1503 03.82 (P04C01)

page 1 of 2

**EUROPEAN SEARCH REPORT**

Europäisches
Patentamt

European
Patent Office

Office européen
des brevets

**Application Number**

EP 24 16 6467

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | NEMANIC VINCENC: "Hydrogen permeation barriers: Basic requirements, materials selection, deposition methods, and quality evaluation", NUCLEAR MATERIALS AND ENERGY, [Online] vol. 19, 5 April 2019 (2019-04-05), pages 451-457, XP093037875, ISSN: 2352-1791, DOI: 10.1016/j.nme.2019.04.001 Retrieved from the Internet: URL:https://www.sciencedirect.com/science/article/pii/S2352179119300109/pdfft?md5=76bbe4a9b4a12bfc44ace22f8464b613&pid=1-s2.0-S2352179119300109-main.pdf> * the whole document * ----- | 1-15 | |
| | | | **TECHNICAL FIELDS SEARCHED (IPC)** |

The present search report has been drawn up for all claims

| Place of search | Date of completion of the search | Examiner |
|---|---|---|
| The Hague | 17 August 2024 | Martinavicius, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130171442 A1

**Non-patent literature cited in the description**

- **JONES et al.** Materials for the Hydrogen Economy. CRC, 2007
- Tritium Barriers and Tritium Diffusion in Fusion Reactors. **CAUSEY** ; **R. J. KONINGS et al.** Comprehensive Nuclear Materials. Elsevier, 2012, vol. 4, 511-549
- **ESTEBAN et al.** Hydrogen transport and trapping in Eurofer. *J. Nucl. Mater.*, 2007, 367-370
- **NEMANIČ et al.** Impact of surface oxide on hydrogen permeability of chromium membranes. *Int. J. Hydrog. Energy*, 2023, 9723-9733
- **NEMANIČ V.** Hydrogen permeation barriers: basic requirements, materials selection, deposition methods, and quality evaluation. *Nucl. Mater. Energy*, 2019, vol. 19, 451-457
- **HENDERSON et al.** The interaction of water with solid surfaces: fundamental aspects revisited. *Surf. Sci. Rep.*, 2002, vol. 46, 1-308
- **ANDREW et al.** Models for hydrogen permeation in metals. *J. Appl. Phys.*, 1992, vol. 72, 2749-2757
- **SHIPILEVSKY et al.** Competition of bulk and surface processes in the kinetic of hydrogen and nitrogen evolution from metals into vacuum. *Surface Science*, 1989, vol. 216, 509-527
- **STEFFEN et al.** Prevention of hydrogen accumulation inside the vacuum vessel pressure suppression system of the ITER facility by means of passive autocatalytic recombiners. *Intl. J. Hydrog. Energy*, 2019, vol. 44, 8971-8980